(19) Europäisches Patentamt

European Patent Office

Office européen des brevets

(11) **EP 0 853 792 B1**

(12) **EUROPEAN PATENT SPECIFICATION**

(45) Date of publication and mention
of the grant of the patent:
**29.01.2003   Bulletin 2003/05**

(21) Application number: **96933702.1**

(22) Date of filing: **02.10.1996**

(51) Int Cl.[7]: **G06F 17/50**

(86) International application number:
**PCT/SE96/01236**

(87) International publication number:
**WO 97/013209 (10.04.1997 Gazette 1997/16)**

(54) **METHOD OF PRODUCING A DIGITAL SIGNAL PROCESSOR**

VERFAHREN ZUM HERSTELLEN EINES DIGITALEN SIGNALPROZESSORS

PROCEDE DE PRODUCTION D'UN PROCESSEUR DE SIGNAUX NUMERIQUES

(84) Designated Contracting States:
**DE ES FI FR GB IT NL SE**

(30) Priority:  **03.10.1995  SE 9503432
05.03.1996  SE 9600854**

(43) Date of publication of application:
**22.07.1998   Bulletin 1998/30**

(73) Proprietor: **TELEFONAKTIEBOLAGET L M
ERICSSON (publ)
126 25 Stockholm (SE)**

(72) Inventor: **ANDERSSON, Röjas, Karl-Gunnar
S-183 44 Täby (SE)**

(74) Representative: **Rosenquist, Per Olof
Bergenstrahle & Lindvall AB,
P.O. Box 17704
118 93 Stockholm (SE)**

(56) References cited:
- **IEEE JOURNAL OF SOLID-STATE CIRCUITS, Volume 24, No. 2, April 1989, BAHER S. HAROUN et al., "Spaid: an Architectural Synthesis Tool for DSP Custom Applications", pages 426-427.**
- **IEEE TRANSACTIONS ON COMPUTER-AIDED DESIGN, Volume 9, No. 9, Sept 1990, GERT GOOSSENS et al., "An Efficient Microcode Compiler for Application Specific DSP Processors", pages 925-926.**
- **DEPARTMENT OF APPLIED ELECTRONICS, 1996, (Sweden), VIKTOR ÖWALL, "Synthesis of Controllers from a Range of Controller Architectures", pages 102-105, "8.1".**
- **IEEE TRANSACTIONS ON COMPUTER-AIDED DESIGN, Volume 10, No. 4, April 1991, C. BERNARD SHUNG et al., "An Integrated CAD System for Algorithm-Specific IC Design", pages 447-449.**
- **DOCTORAL DISSERTATION, May 1990, (Sweden), MATS TORKELSON, "Design of Application Specific Digital Signal Processors", part 2, pages 3-23; part 6, pages 585-586"2"; part 9, page 50 "Implementation".**

## EP 0 853 792 B1

**Description**

The present invention relates to a method of producing programmable processors and also a method using a special technique for generation of behavioral models for programmable processors.

BACKGROUND OF THE INVENTION AND STATE OF THE ART

Future telecommunication systems will put high requirements on flexibility, short design time and design reuse for digital signal processing systems due to the fast changing market. Other requirements are low power consumption and small silicon area. For the portable device market, there will be battery powered terminals for speech, data, image and video communication. In stationary systems the integration will increase, which leads to higher power density in the systems. The power dissipation problem has to be attacked on all levels from system level, algorithm, architecture down to the devices and the semiconductor manufacturing process.

The price/performance required by different applications is not possible to achieve using standard digital signal processors (DSPs). Thus, a DSP in those cases has to be specifically designed for the actual application (ASDSP, Application Specific DSP). Then, a possibility may be to use the processor core of a standard DSP together with memories for data and program, which are customized for the actual application. Input/output ports and peripheral functions can be designed as blocks on the same chip (Custom DSP).

The limitations associated with a custom DSP approach is fixed wordlength, fixed functions and the speed of the core, limited by the architecture. The architecture of a complete standard DSP core is instead designed to be able to handle many different applications, resulting in not used silicon area for many applications, which may have special needs for functionality and wordlength.

A class of DSP is designated the algorithm specific DSPs. The architecture and functionality in this class of DSPs are designed from the actual algorithm to be implemented, and consideration is taken of the system requirements, in regard of speed, silicon area, power dissipation and flexibility. DSPs of this class are designed by means of automatic compiler tools or pure full-custom design comprising conventional tools for silicon design.

Present techniques of designing DSPs include those which use a behavioral representation that specifies the algorithm that is implemented in the processor as a program, and a structural description of the processor hardware modules and their logical connections. One of these systems is the LAGER system developed at Berkeley University, see Shung, Jain, Rimey, Wang, Srivastava, Richards, Lettang, Azim, Thon, Hilfinger, Rabaey, Brodersen: "An Integrated CAD System for Algorithm-Specific IC Design", IEEE Transactions on computer-aided design. vol. 10, No. 4, April 1991.

A second system has been developed at the University of Lund, Sweden, see Mats Torkelsson: "Design of Application Specific Digital Signal Processors", Ph.D. thesis, Lund University, Sweden, June 1990, Viktor Öwall: "Synthesis of Controllers from a Range of Controller Architectures", Ph.D. thesis, Lund University, Sweden, December 1994, Chapter 8, pp. 102 -. This system is similar to the LAGER system and uses a behavioral description of the processor architecture to extract a set of micro-operations. The extracted micro-operation set constitutes the available operation set, used for the micro-programming of the processor. The microcode program is a description of the algorithm which is implemented, and additional declarations such as memories.

DESCRIPTION OF THE INVENTION

There is thus a need for a more semicustom oriented approach than that used in the prior art. A design environment should be provided that will fill the gap between the automated compiler tools and the traditional full-custom DSP design. In the design procedure it is important to take advantage of all the benefits in the full-custom approach and to use them in a semicustom approach. The automated design used by the compilers, scheduling and resource allocation is difficult to make efficiently in a computer program. A key concept should then be to put the designer in place, to analyze the algorithm and create the architecture manually and use the tools as an interactive aid in the design work.

It is thus an object of the invention to provide a design-environment for design space exploration of processors.

It is a further object to provide a partitioning of an algorithm to one or several computational units or processors and also to provide a possibility of doing performance estimates.

The present invention is defined in the appended claims.

Thus an iterative process can be provided comprising analysing the algorithm, defining the architecture, writing microcode and exploring the design space by simulation of the microcode.

The invention is thus based on a methodology for generation of behavioral models for programmable processors. Such a processor is constituted of hardware modules like computational units and a control unit. The processor executes operations from a program stored in the control unit. The behavioral model is a description of the processor hardware and the program executed by the processor.

The main advantage of the suggested approach is the modelling of the processor and the microcode-program to be executed in the processor. The structural model of the processor architecture and the microcode-program (a subset of C) are included in the one and same textfile.

The microcode-program is an implicit description of the architecture and by using the present methodology there is no need for an explicit structural description of the processor architecture.

The environment supports the implementation of an algorithm into a micro-programmed application specific processor architecture.

The variable names in the microcode match the instance names in the graphical architecture description. Assignment of data between different variables (registers, memories) corresponds to the connectivity in the architecture. The microcode is written in a high-level assembly language which in a preferred embodiment is a subset of the C-language.

This single format behavioral model of the processor and the associated microcode program can be linked together with "bit-true" simulation models from a library, where e.g. C++ overload operators can then be used. The linked code can then be used as the behavioral simulation model on an event-driven simulator or executed as a plain high-level language program. Providing an asynchronous I/O interface on the processor it will be possible to run several processors concurrently in the simulator, communicating by means of asynchronous hand-shaking.

This way of writing microcode and simulating gives a very flexible way of mapping an algorithm onto a processor structure. It is easy to make changes in the micro-program code by means of a text-editor and then resimulating. The architecture description can be graphically visualised on a sheet of paper, as a support for the application engineer. There is no need for a computer readable architecture because of the implicit description of the architecture in the microcode.

Traditionally, at the company Ericsson the microcode has been generated into a Register Transfer Level (RTL) model and simulated together with the hardware model. The drawback of this approach is that the microcode is not verified before it is included in the hardware RTL-model. When verifying the hardware it is difficult to say whether the errors are in the hardware, or software, or both. The simulation time on this level is also several magnitudes longer than doing simulations on the behavioral level.

Using the tools like LAGER, discussed above, the microcode has been generated from the algorithm by a compiler, doing resource allocation, scheduling and assignment. The input to the compiler has been the structural and behavioral descriptions. This way of automatically generating a processor model is not very efficient in terms of hardware area, power consumption and cycle count. Therefore a more manual way of analysing the algorithm and writing microcode programs is preferable (high level).

In the prior art, input is needed from both the processor architecture such as a structural description, an extraction of operations and from the algorithm (the microcode program) for generating the complete processor model. The prior approach requires tools for extracting the operations needed for the processor model.

The steps of the design process of integrated circuits can be partitioned into two major groups, the functional design and the implementation of the circuit into hardware. The design process can be characterized as both Top Down and Bottom Up. This means that the information flow between the two levels is bidirectional. There is a Top Down approach from the algorithm level down to the logic level with a refinement process from level to level. There is also Bottom Up flow of information of what is available in the target library in terms of logical and arithmetic functions and the performance of these functions (speed, area, power consumption). The present invention is in the functional design domain and the modelling of an application specific processor (ASP) and associated microcode program into a behavioral model.

BRIEF DESCRIPTION OF THE DRAWINGS

The invention will now be described in detail by way of non-limiting specific embodiments with reference to the accompanying drawings in which:

- Fig. 1 is a block diagram illustrating various elements used in producing a digital signal processor,
- Fig. 2a is a schematic view of the process blocks of a preprocessor and a generation module,
- Fig. 2b is a flow diagram illustrating the steps executed by the preprocessor and generation module of Fig. 2a,
- Fig. 3 is an example of a top level template of a processor,
- Fig. 4 is an example of the module level of a processor,
- Fig. 5 are examples of a control unit template and an address path template included in a processor illustrating registers and individual lines,
- Fig. 6 is an example of a data path architecture as specified in a textfile,
- Figs. 7a and 7b are pictures illustrating a program statement and its correspondence in graphical form.

DESCRIPTION OF A PREFERRED EMBODIMENT

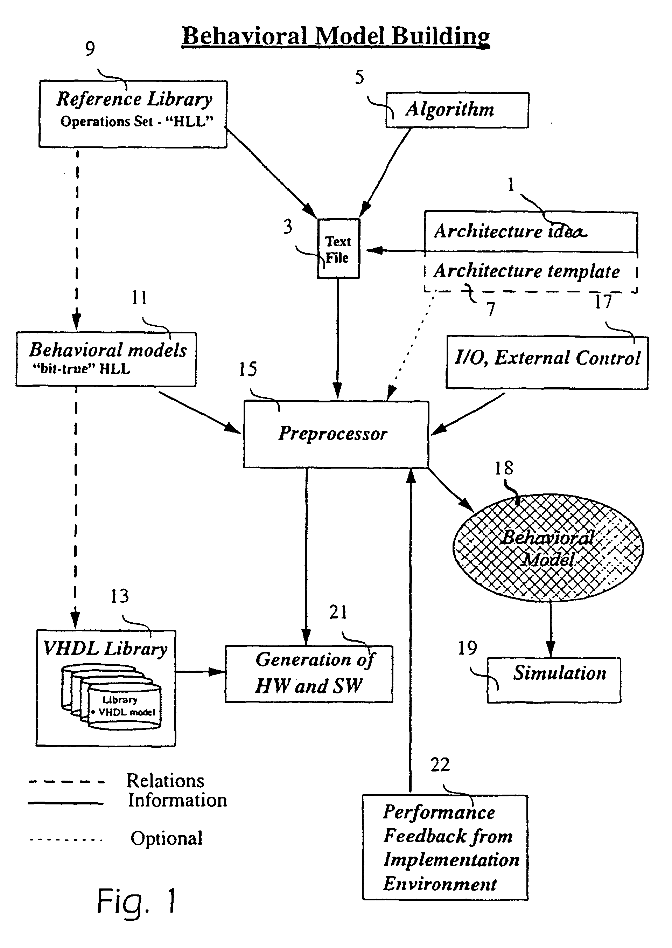

Fig. 1 is a schematic picture describing the information flow and the relations between different levels in the construction process of a digital signal processor comprising designing and modelling the processor in a functional design environment and producing the necessary hardware for manufacture of the processor on an IC-chip. The start step is an architectural idea indicated at 1 which is the mental picture or idea of the architecture of a processor that is to be produced. This architecture does not have to exist as a graphical picture on paper or a display screen of a computer but may be thought of as some imagined apparatus performing some required functions.

A microcode program is written in a high level language (HLL) and the result is a textfile indicated at 3. The code is written after analysing the functions which are to be executed by the processor, as indicated by the block "Algorithm" at 5, and also the desired or required architecture of the processor, as indicated by the block "Architecture templates" 7. The microcode program specifies implicitly the entire functional construction of the processor, that is all registers, memories, units for performing operations, lines and buses between the components, input/output devices, external lines and buses, etc. The syntax and operations/operators of the microcode textfile must conform to rules, definitions, etc. as stored in a reference library 9.

The definitions in the reference library 9 correspond more or less directly to behavioral models as stored in a library 11 which comprises "bit-true" models, also represented in a high level language. The reference library 9 contains an operation set with associated behavioral models as appears from the following table.

| Models | Representation/Function | Format |
|---|---|---|
| Operation set | Primitive operations (see below) Data path functions (see below) Address and control path functions | Text file |
| Processor template | Sheet of paper or computer stored | Graphic |
| Control unit templates | Sheet of paper or computer stored | Graphic |
| Behavioral models | Bit-true simulation models | HLL |

The behaviour models of the library 11 in turn correspond, also more or less directly, to various representations stored in a target or VHDL library 13. For each operation and function there will thus be a hardware implementation in the target library 13. Performance like speed, area and power dissipation and other parameters and associated information can be accessed in the actual target library 13 and transferred into the behavioral model.

The target library 13 can only comprise the VHDL (RTL) model, and the decision on the actual hardware implementation for producing a desired silicon chip can be taken in a later phase in a design project. If this is the case, no absolute values of area, speed or power consumption can be taken, only relative estimates can be made.

A complete design environment consists of two special environments. The first one, the functional design environment is the one that is important herein. The second one is the implementation design environment which is a traditional design environment for silicon ASIC design.

The interface between these two environments are the VHDL models, which are models of the processor hardware on a register transfer level, RTL. The models exist for registers, memories, arithmetic functions and control unit template and are standardized.

Specifically, the target library or VHDL library 13 thus contains models in VHDL format at the Register Transfer Level (RTL). The models are modules of the DSP hardware and structural templates for different levels.

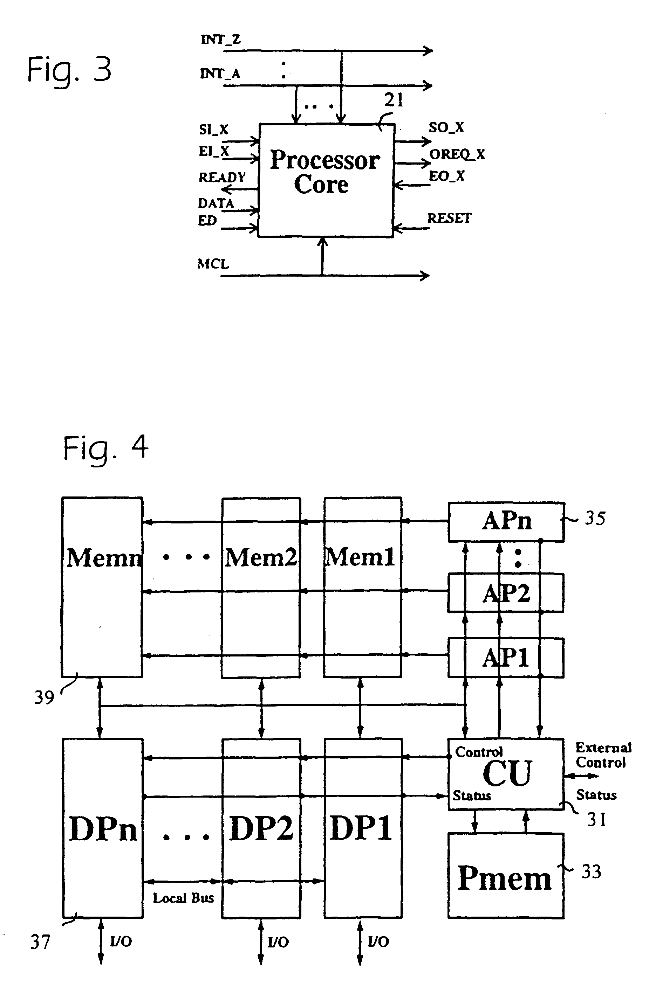

The top level consists of the signal processor core including I/O definitions, as will be described with reference to Fig. 3.

The second level, as will be described in detail with reference to Fig. 4, is built of instances placed in the core. A core consists of one Control Unit module, CU, and an internal or external Program memory, Pmem. The following modules can have one or several instances, Address Path AP, Data Path DP and Memories Mem. A core can thus have several DP modules and/or AP modules. Each of the modules have one or several templates in the structural VHDL description.

The third level is the lowest level which consists of symbols like Adders, Registers, Multipliers, Shifters, ... and more complex functions added to the library for special purposes or needs. These modules and memories are modelled in VHDL as ENTITY and ARCHITECTURE descriptions, these words in capitals being reserved words in VHDL.

The microcode program is written in the high level language as specified in the reference library 9. The code is written after the analysis phase of the algorithm and the architecture definition, and a model 18 of the processor and the program executed on the processor, will be the result in the textfile. To be able to execute the model on a computer the bit-true "Behavioral models" of block 11 have to be linked into the model, and also functions for the Input and Output of data together with synchronisation functions.

The completed "Behavioral model" 18 can then be used for simulation 19 and as a source for the generation 21 of hardware.

To be able to use the model as specified by the textfile 3 it is processed by a preprocessor program 15 run on a computer. In the execution of the preprocessor program 15 it will need the bit true behavioral models in the library 11, as referenced by the operations in the textfile 3, performance information from an implementation environment 22, if available, and also, for simulation purposes, functions for controlling the input and output of suitable signals simulating exterior stimuli, the main code block in a external control block 17, to wrap the behavioral models and various functions and include files into a complete program in 18, that can be linked into an appropriate simulator 19.

When the various items are needed, they are linked to the main program 18 as produced by the block 15, which is the complete behavioral model of a processor core 21, if they are in the shape of computer stored program routines or picture details, and otherwise they may be suitably activated.

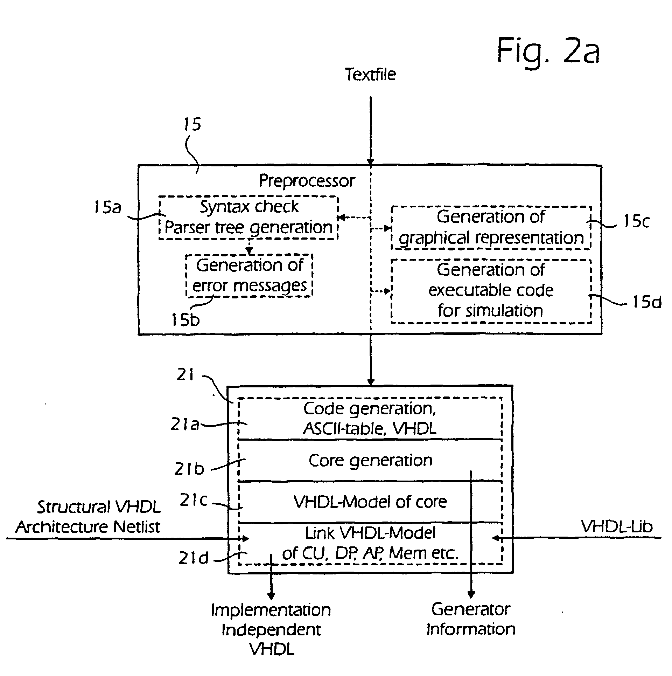

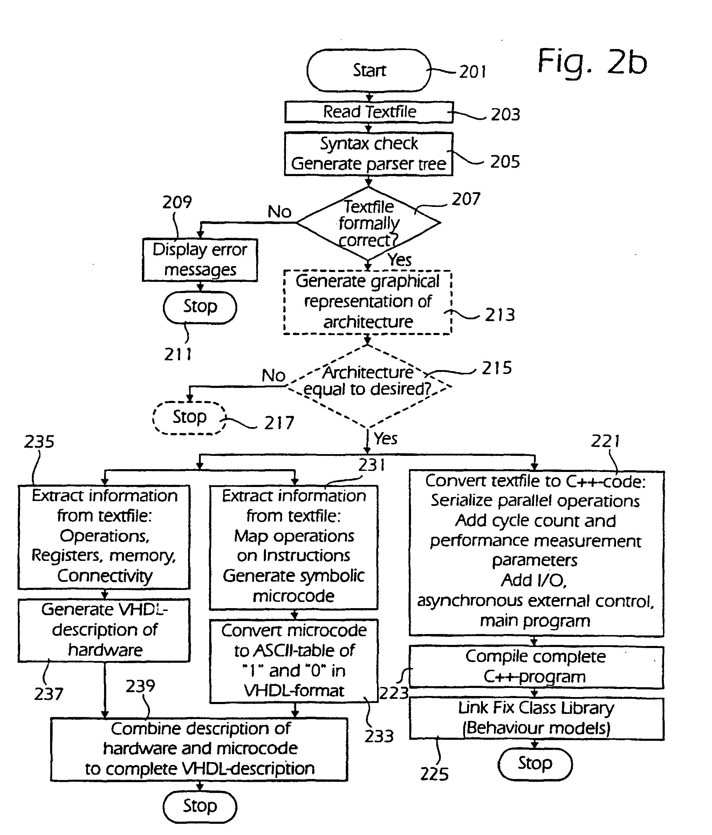

The complete textfile as stored in the block 3 is thus used by the preprocessor program 15 for producing a program for simulation of the operation of the designed processor to be run in the block 19, and also as a source for the generation of hardware and software, as indicated by the block 21, see the picture of Fig. 2a illustrating the interrelation of the preprocessor 15 and the generation module 21 and showing the program parts associated with these modules. A corresponding flow diagram is shown in Fig. 2b.

The preprocessor 15 performs the following steps: After a start block 201 the textfile stored in 3 is read in a block 203. Then the textfile is checked for syntax errors in a block 205, see also block 15a of Fig. 2a. If errors are encountered as tested in a block 207, they are indicated by displaying or generating appropriate errors messages, see block 209 and 15b. Then the preprocessor will halt the operation in a block 211, awaiting a new textfile to be processed. If the textfile has a correct form it can be processed further, for example in an optional step 15c or a block 213 where a graphical picture of the architecture as represented by the textfile is produced, e.g. manually on a piece of paper. Then this picture can be approved by a comparison to the intended architecture, as for example represented by graphical pictures showed on the monitor of a computer and a netlist, as indicated by the block 215. The comparison can be made automatically by the computer or visually by the processor designer, the designer then indicating by some manual input operation whether the architecture represented by the textfile matches the desired architecture.

If the textfile is formally correct, the textfile can be processed further by the preprocessor for producing the behavioral model and thus a base for a simulation of the architecture, as is indicated by the block 15d of Fig. 2a and by the procedural steps 221 - 225 of Fig. 2b. Thus in the first step 221 the textfile is converted to the real C++-code, meaning substantially that parallel operations, as will be described more hereinafter, are converted to be performed serially or consecutively, one after the other. For simulation purposes, instructions for cycle count and measurement parameters are added to the code. Then, also operations representing I/O and external, asynchronous control are added, as obtained from the block 17 of Fig. 1. For forming a complete executable program, a main program, "main ()", is added in the conventional C-programming style. Then the C++-code is compiled in a step 223 and the compiled program is linked to other program modules in a step 225. Then an executable program has been obtained, that in a sense can said to be the "behaviour model" of block 18 of Fig. 1 and also can be input to the block 19 for simulating the architecture defined by the textfile in 3.

The VHDL generation part as indicated by the block 21 of Fig. 1, generates a structural, implementation independent VHDL model, including data path, control unit and program memory, from the microcode and architecture description, as originally specified in the textfile of block 3. The procedures performed in the block 21 are illustrated by the sub-blocks 21a - 21d of Fig. 2a and the steps 231 - 239 of Fig. 2b, all the operations being based on the textfile in 3.

The generation of the actual microprograms to be executed in the signal processor to be produced and especially in the Control Unit module thereof is made in the block 21a of the generation block 21. This generation can possibly use some intermediate converted file comprising microinstructions as produced by the preprocessor 15 in the block 15d and substep 221, or else use the original textfile stored in 3. Thus in the step 221 generally information is extracted from the textfile in 3 so that operations can be mapped on the actual instructions of the language to be used and so that a symbolic microcode can be generated. In the successive substep 233 the microcode obtained is converted a suitable table in the VHDL-format containing e.g. a binary table comprising a sequence of the ASCII-characters "1" and "0". This table thus comprises the program that is to go into the VHDL model for the program memory and is the microprogram to be executed by the CU.

Information on hardware requirements such as wordlength, registers, operations, memory, the connection lines therebetween, etc. is extracted from the program code in 3 and used for generation of the processor core in a block 21b, as illustrated also in the substep 235 of Fig. 2b. This extracted, combined information can be output or displayed as generator information to the processor designer who can use it for manual editing or manual generation, meaning that then the process is stopped after the step 235, awaiting some signal for continuing the sequential procedural steps. More particularly, the processor core including I/O definitions is generated from the textfile and therefrom the more detailed architecture including associated operations, registers, memories are used for forming the control unit and the appropriate APs, DPs, Mems and how these modules are connected.

Then in a block 21c and a step 237 the VHDL-model of the processor core hardware is generated and it is thus a structural, implementation independent VHDL model, including data path or paths, address path or paths, control unit and program memory, from the architecture description of block 21b and the substep 235.

Finally, in the block 21d and substep 239 the hardware description of the processor core and the VHDL-microcode table are linked or combined in a block 21d and the substep 239 to form a complete VHDL-description. Then a structural VHDL architecture netlist is also used, which is a structural specification of hardware according to the VHDL-standard. This structural specification can be extracted from a graphical representation or from a VHDL-template and comprises in particular the connections of the control unit module CU which cannot be extracted from the textfile. It is thus a netlist of the connectivity of the modules of the processor, as illustrated in Figs. 3 - 6. In the linking process naturally also templates from the VHDL-lib 13 are used. Thus an implementation independent VHDL-model is obtained, that is used for actually producing the signal processor. Thus in block 21d VHDL lowest level models, that is RTL models for Registers, Arithmetic functions, memories, which are referenced from the VHDL library in 13, are linked together, first internally to the modules DP, AP and Mem and then at the top level, that is including the I/O-functions. The VHDL netlist links the different modules, compare items DP_1..N, AP_1..N, Mem_1..N, Pmem and CU, as illustrated in Fig. 4.

The program memory Pmem may be implemented as ROM or RAM, internal or external to the core.

The objectives in simulating the microcode are (the simulation is made by generation of executable code in block 15d, this code being equivalent to the actual microcode to be used that is generated in block 21):

- verification of the microcode.
- obtaining the number of cycles required by the application.
- estimating power consumption.
- estimating the physical area required on the chip to be produced.

The architecture of a processor to be designed is represented in three hierarchical levels. The top level consists of the processor core 23 comprising I/O definitions, see the graphical representation of Fig. 3.

There are thus inputs for interrupt signals, INT_A ... INT_Z, an input for a reset signal RESET for resetting the processor core, inputs/outputs for data transfer, DATA, for connection to some suitable data bus, and various other inputs/outputs carrying signals that are needed by the processor for the exterior communication.

While the internal design of the processor core assumes a synchronous design style, asynchronous handshaking is supported for the I/O communication external to the core. An algorithm or a system that the processor is to perform or implement, can be divided on several processor cores on the same chip or different chips. The asynchronous handshaking and interrupt/acknowledge signalling make it easy to partition the system on several processor cores and to make design space exploration by behaviour simulation.

Functions like PCM-coding, FFT (Fast Fourier Transform) or DCT (Discrete Cosine Transform) can either be external or internal to a processor core 23. If a function is internal (i.e. must fit within a datapath module) all the models have to exist for the function in a processor library (behavioural models) and an implementation of the function has to exist in the VHDL library 13. If a function is external to the processor core 23, there are no other requirements on the function other than I/O communication and asynchronous handshaking. For simulation purposes, of course the external control block should then be capable of providing the correct signals.

The second level, see Fig. 4, is built of instances or modules placed in the core 23. A core 23 thus comprises one control unit module 31, CU, and an internal or external program memory 33, Pmem. The following modules can have one or several instances. Address path 35, AP1, AP2, ..., APn, data path 37, DP1, DP2, ...., DPn and memories 39, Mem1, Mem2, ..., Mem3. A core 23 can have several DP modules 37 and/or AP modules 35. This is a trade-off that the application engineer/designer has to do when he defines the architecture for a core 23, that is either to partition the algorithm on several DPs 37 in the same core 23 or to use several cores 23 to partition the algorithm onto.

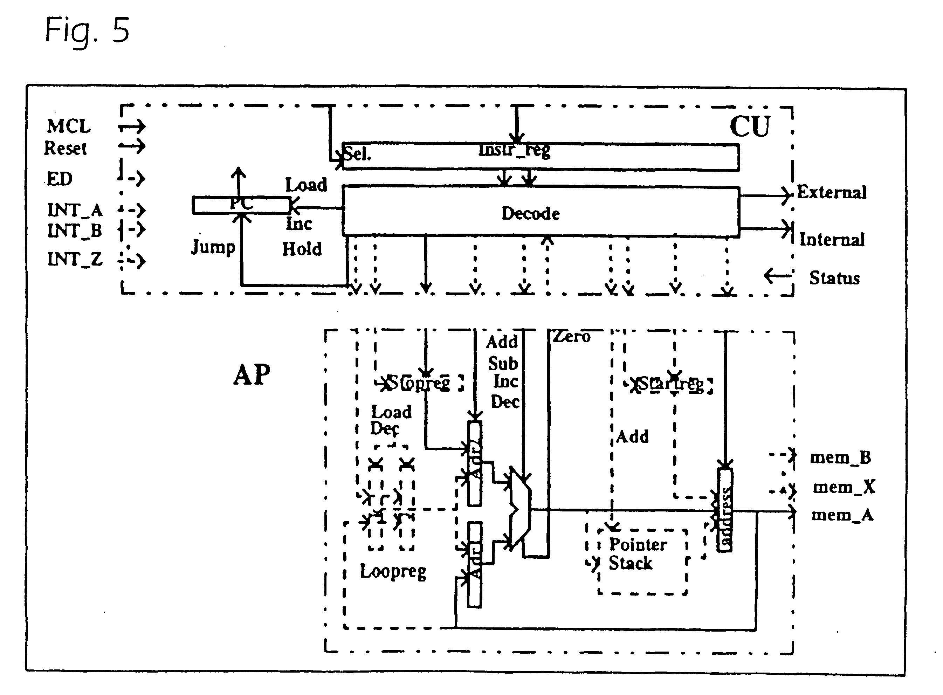

Each of the above modules has one or several templates. A template is a module which is predefined to a certain extent. Fig. 5 shows an example of the templates for the CU 31 and the APs 35, where the parts drawn in solid lines form the basic structure and the dotted lines is an example of how to use the templates to build an actual CU with an associated AP for a certain application.

The purpose of such a template is to put limitations on the modules and to keep a structured design methodology. This will simplify the pipelining and timing analysis for implementing the structure on a silicon chip. Thus the main templates should be specified so that they have a balance between limitation and flexibility in the architecture.

Templates like those illustrated in Fig. 5 are used for writing the textfile stored in the block 3 and then the definitions as stored in the reference library 9 are used. This will form a third level which is the lowest level and comprises symbols like adders, registers, multiplier, shifters, ... or more complex functions added to the library for special purpose needs, where the library comprises the reference library, the behavioral models and the VHDL library. The primitive operations/functions and other functions must correspond to the operation code set in the reference library 9.

The reference library 9 contains the declarations and the syntax information of arithmetic operations, or as defined here, the primitive operations/functions that can be executed in the datapath and addresspath. The operations are:

- Primitive operations
  "+", "-", "++", "--", "*", "<<", ">>"
- Primitive functions (function modules in HW).
  DP: abs(), norm(), div(), dct(), fft()
  AP: buff(), end buff(), buff_p()
- Dataflow (assignment operator)
  "="

where abs() means the function of taking the absolute value,
norm() means normalization,
div() means division,
dct() the discrete cosine transform,
fft() the fast fourier transform.

These are only examples of functions which can be included in the datapath.

An expression to be used in the textfile as stored in the block 3 can have the form:

$$Acc1..n = \pm(a \pm b);$$

where the accumulator to the left is a register Acc1, Acc2, ..., Accn, not shown, in one of the datapath modules DP and can be assigned, as indicated by the symbol "=", the sum or difference of the registers "a" and "b". The registers are declared as variables in the textfile stored in 3.

The primitive operators "<<" and ">>" are arithmetic left and right shifts respectively. A constant "k" or variable determines the number of shift steps:

$$Acc1..n = \pm c << k (Acc1..0 \pm b);$$

$$Acc1..n = \pm c >> k (Acc1..0 \pm b);$$

The assignment of data describes the dataflow inside the processor. Data can be assigned (transferred) between registers, memories and Input/Output registers.

The functions can be called as an ordinary function in a HLL:

$$Acc1..n = abs(a);$$

Here the absolute value of the content in a register "a" is loaded in an accumulator Acc1, ..., Accn.

The functions for a datapath 37 and an addresspath 35 can be different and are normally so. The AP 35 has for example a circular buffer function for calculation of the address pointer for a circular buffer stored in memory:

```
const int *buff_p(i mem_A) = adr        ;Init pointer i

        .

        .

buffer(i mem_A start stop)              ;Circular buffer
{
    (statements)
    mem_A++                             ;Increment pointer
    (statements)
}
end_buff(i mem_A)                       ;Store pointer on stack
```

The control flow in the program is controlled by the program counter, jumps, conditional jumps and loops. The increment of the program counter is not explicitly expressed in the program code. The counter is incremented by default for each statement in the program code, unless it is overridden by any of the control functions. However, each statement is ended in the program code by a semicolon ";", which can be seen as indicating an increment of the program counter.

Parallel operations can be executed in a microinstruction or statement (concatenation of several microoperations). The parallel micro-operations are separated by a comma "," in the program code.

The operations controlling the dataflow in the processor are:

- Conditional operations
  <op> ::= "<", ">", "<=", ">=", "==", "!0"
- Conditional statements
  if(), else
- Loops
  for(), for(;;)
- Unconditional statements
  goto label
- Control functions (implemented in the control unit)
  hold(), wait(), pwd(), en_int(), disab_int()

All the conditional and control functions are implemented in the control unit hardware and have not to be implemented in the reference or behavioral libraries 9 or 11, more than possibly the syntax thereof may be declared in the reference library 9. This approach of modelling processors takes advantage of the actual high level language, where these functions are all included implicitly, and does not need any separate modelling of the functions on the behavioral level.

A conditional statement can be of the form:

```
        if(a <op> b)                    ;Conditional Jump
            {
              .

              .
            }
        else
            {
              .

              .
            }


                                or


        if(a <op> b)                    ;Single operation
            <operation>;
```

A loop control function is written as a "For" loop:

```
        for (k = m; k >= 0; k--)        ;Load loop counter
            {
              .

              .
            }                           ;Jump to decrement loop counter


                        or


        for (k = m; k >= 0; k--)        ;Single repeat
            <operation>;


                        or


        for (;;)                        ;Infinite loop
```

The loop counter "k" is located in one of the addresspaths 35, and is loaded with an initial value "m" and is decremented to zero. This is a restriction on the function, the loop counter can only be decremented to zero. It is more efficient from a hardware point of view to detect a negative state. This is a minor drawback for the programmer and can be handled easily.

The unconditional jump instruction is loading the program counter with the program address of the label:

goto label    ;Jump to address

The following control functions affect the program flow, holding the program counter or loading it with a new value (label):

```
hold(n)            ;Stop execution n cycles
wait( < label > )  ;Wait for wakeup
pwd( < label > )   ;Power down
en_int(A...Z)      ;Enable interrupt
disab_int(A...Z)   ;Disable interrupt
```

The external interrupts are controlled by two functions Enable and Disable. The parameters are the signals on the interrupt input ports INT_A, ..., INT_Z. There can be any number of interrupt ports from zero to as many as required by the application. The wait and pwd functions are terminated with an external interrupt or reset signal.

The microcode program which is stored in the block 3 is written using a conventional text editor and utilises a semantic model of the processor and the microcode program, executed on the target processor.

The transformation process from the algorithm description down to the textfile in the block 3 is done using manual evaluation. The process is iterative and can be defined in the following way:

- Analysis of the algorithm, block 5, and system performance.
- Definition of the target architecture, block 1, based on processor templates, block 7.
- Writing program-code, stored in 3, based on the declared primitive operations and functions in the reference library 9.

The process of writing/editing the code in the textfile and updating the architecture is repeated until an acceptable result is achieved. The code is first syntax checked in the preprocessor and then used as the source code by the preprocessor program of block 15 in the following steps:

- A syntax check of the textfile by calling the definitions of the reference library 9.
- An optional check of correspondence of the processor as specified by the textfile with the contemplated architecture. In the preprocessor 15, for example, a graphical illustration of the logic construction of the processor or components thereof can be generated on a display screen. However, preferably the architecture can be generated manually by the designer as a graphical illustration of the logic construction of the processor or components thereof on a display screen.
- A preprocessing of the textfile source code.

  - - Serializing parallel operations, that is substituting ";" for ",".
  - - Adding performance measurement parameters, as taken from the block 22.

- Setting up, if necessary for simulation or performance tests, I/0, external control in the block 17 (core wrapper).
- Compiling source code module to relocatable object code.
- Linking of behavioral, "bit-true" functions.

The linked compiled object code can be used for simulation on an appropriate simulator.

The program code of the textfile stored in the block 3 comprises two parts, the declaration part and a body with program statements. In the declaration part the allocation of memory is specified. Memory in this case comprise RAM, ROM and registers. The registers can be of three different types: input, output and register. The input and output registers have to be specified separately because of the I/O handshaking.

Below is an example on a declaration:

```
REG Mereg[16], Mareg[12], Sacc[22], Acc[22];
INPUT Ireg[16];
OUTPUT Oreg[16] ;
RAM Mem1[256, 16];
ROM Mem2[1024, 16];
```

where the first line specifies typical storage elements and the last two lines specifies a typical working storage and storage fixed data respectively. The middle lines specify input/output registers. The program memory Pmem must be specified otherwise.

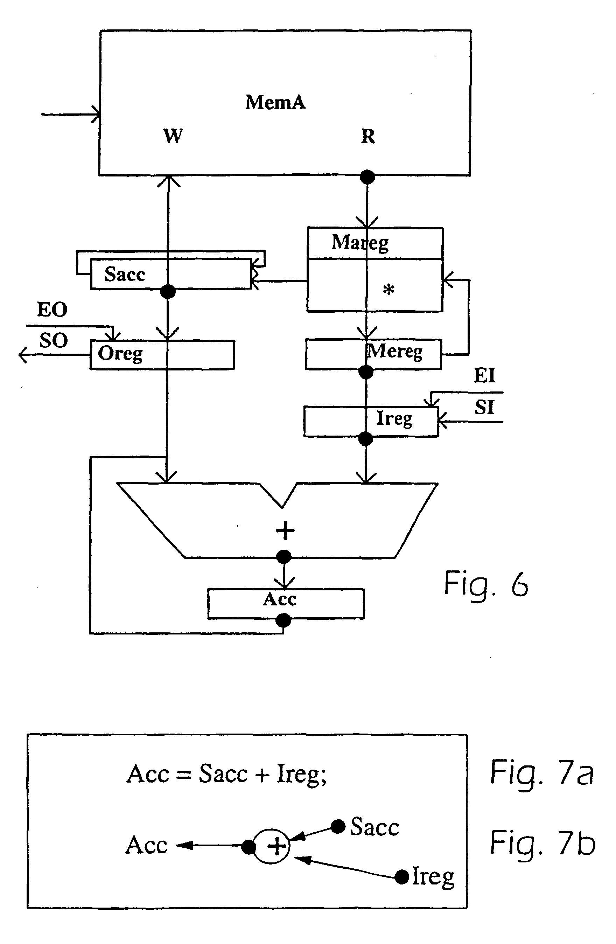

The architecture for the above declaration can be seen in Fig. 6 illustrating the architecture of a datapath 37.

Beside the storage, that is declared above, there are two primitive operations used in this architecture, multiplication "*" and addition "+". The connectivity or the static data flow is described by the arrows and the bullets in Fig. 6. An arrow indicates an input to the module and a bullet indicates that the output of a module is connected to the bus.

The dynamic data flow, see Figs. 7a and 7b, on the other hand is defined by the statements in the program code and is a flow from the right-hand side to the left-hand side in the program-code of the textfile at a specific time, when the statements are executed. This is the same as the "bullet to arrow" notation when a transfer takes place on the bus. The statements on the other hand are executed from the micro-instructions in the program memory as controlled by CU and are normally defined as the control flow.

In the architecture all the storage elements has an instance name and this name must be the same as the variable name in the declaration list. To summarize the declarations:

- Primitive operations are declared in the reference library 9.
- Storage elements are declared in the program textfile.

An instance of a primitive is identified in the architecture by its connectivity. The add-operation "+" in Fig. 6 is identified by the connection to Ireg, Mereg on one of the operand inputs, and the connection to Acc_bullet and Sacc on the other operand input. The output is identified by the connection to the input of Sacc. This is the same as the semantic description:

$$Acc = Acc + Ireg;$$

The output here is the assignment to Acc on the left-hand side of the expression.

However, there can be an ambiguity in this way of identifying the operators, if we have two, exactly the same operators connected to the same set of registers for both the inputs and the output. Then it is not possible to decide which one to use. This is not a normal way of doing design and should be avoided. There can for example be two similar operations which are connected in parallel. They can be distinguished by using different symbols for the operation. Normally, when using parallel operations of the same type, they are at least connected to different output registers.

The program code of the textfile describes the data/control flow in the processor to be produced and is in the same way a semantic description of the connectivity of the processor as discussed above. Another way of expressing the relationship between program code and processor architecture is the fact that a computer program is an implicit description of the processor architecture for low level programming like Assembler programming. This fact is exploited here, to put restrictions on the architecture, by using templates and to have strict rules for the program coding, by using a reference library 9. Below is an example of a program written for the target DP-architecture of Fig. 6.

From the declaration of the storage element we can see that the wordlengths of some of the elements are different from that of others. The evaluation and generation program and the hardware assumes most significant assignment of a word if the left-hand side has a shorter wordlength. If not most significant assignment, the bitfield for the variable has to be specified, e.g.: Mem = Acc[6, 21];

The address calculation "adr" and the loop control variable (register) "k" is based on the controller template shown in Fig. 4.

The operations in bold are operations executed by the data path 37, the other operations or statements specifying functional details.

As can be seen from the program example below, the architecture of the data path 37 can be extracted from the code. This is also the case for the addresspath 35.

```
for(;;)                             // Infinite loop
    {
    adr = 0;                        //Address register is not included in DP
    for(k = 127;k >= O; k--)
        {
        MemA = Acc;                 //Write to memory
        Mareg = MemA,               //Read from memory
        adr = adr + 127,            //adr register incremented in AP
        Oreg = Acc;                 //Accumulator to output
        Mereg = MemA,               //Read from memory
        adr = adr++;
        Acc = Acc + Mereg;
        MemA = Acc;
        Acc = Sacc + Ireg,          //Add Sacc and input
        Sacc = Mareg * Mereg,       //Multiply
        adr = adr-127;
```

To summarize the important features of the method of generating a behavioral model, it can be expressed as follows:

- Definition of the target architecture, based on processor templates.
- Writing program-code in a single textfile description based on declared primitive operations and functions, and a set of syntax and programming rules stored in a reference library.

 - - Primitive operations and functions are declared in the reference library.
 - - Storage element are declared in the program textfile.

- One to one mapping, transformation between abstraction/model levels without any synthesis taking place. There is a one-to-one relation between the levels:

 - - Reference library/textfile        Operations-Functions/Variables.
 - - Behavioral bit-true model        Implemented functions/Variables.
 - - Target architecture        VHDL library/Instances.

- Identify primitives, functions and instances in the target architecture from the program code, based on the fact of the implicit description of the target architecture.

**Claims**

1. A method of producing a digital signal processor having a predetermined structure and predetermined functions comprising the steps of

 - determining an architecture of at least one processor part,
 - making a layout description of the corresponding circuits based on the determined architecture,
 - making the layout of the corresponding circuits based on the layout description,
 - processing a semiconductor chip according to the layout,

**characterized in**

- **that** in making a layout description of a processor part the structure of the processor part is coded as definitions of variables including the particular characteristics of each variable, the variables indicating registers in the processor, and further as operations and/or functions which are to be performed by the processor part using the variables as arguments, and
- **that** these definitions of variables and operations and/or functions are interpreted to form the respective registers and units performing the functions and lines connecting the registers and the units.

2. A method according to claim 1, **characterized in**

- **that** in making the layout description the definitions and the operations and/or functions are written as textfile, and
- **that** the textfile is interpreted sequentially or consecutively, starting from the beginning of the file.

3. A method according to claim 1, **characterized in**

- **that** the definitions of variables and operations and/or functions are made for essentially a whole processor, and
- **that** when making the interpreting, a basic, predetermined structure of the processor is used, the processor thus having at least a control unit associated with a program memory, at least one address path module, at least one data path module and at least one memory module.

4. A method according to claim 3, **characterized in that** the occurrence of an arithmetic operation in the definitions of variables and operations and/or functions signals an arithmetic unit in a data path module, the variables being operated on being interpreted as registers in the data path module.

5. A method according to claim 3, **characterized in that** the operations and/or functions comprise a special operation for performing in parallel or simultaneously operations and/or functions linked by this special operation, the occurrence of this special operation in the definitions of variables and operations and/or functions signalling that the processor is to comprise at least the same number of arithmetic units, each one in a data path module, the variables being operated on being interpreted as registers in the respective data path module.

**Patentansprüche**

1. Verfahren zum Produzieren eines Digitalsignalprozessors mit vorbestimmter Struktur und vorbestimmten Funktionen die folgenden Schritte umfassend:

Bestimmen einer Architektur mindestens eines Prozessorteils;

Erstellen einer Layoutbeschreibung der entsprechenden Schaltungen basierend auf der bestimmten Architektur;

Erstellen des Layouts der entsprechenden Schaltungen basierend auf der Layoutbeschreibung;

Fertigen eines Halbleiterchips entsprechend dem Layout,

**dadurch gekennzeichnet,**
**dass** beim Erstellen einer Layoutbeschreibung eines Prozessorteils die Struktur des Prozessorteils als Definitionen von Variablen kodiert ist einschließlich den speziellen Eigenschaften jeder Variablen, wobei die Variablen Register in dem Prozessor indizieren und außerdem als Operationen und/oder Funktionen, die durchzuführen sind durch den Prozessorteil unter Verwendung der Variablen als Argumente, und
**dass** diese Definitionen von Variablen und Operationen und/oder Funktionen interpretiert werden zum Bilden der jeweiligen Register und Einheiten, die Funktionen und Leitungen ausführend, die die Register und Einheiten verbinden.

2. Verfahren nach Anspruch 1,
**dadurch gekennzeichnet, dass** beim Erstellen der Layoutbeschreibung die Definitionen und Operationen und/oder Funktionen als Textdatei geschrieben werden, und

dass die Textdatei sequentiell oder hintereinander interpretiert wird, beginnend mit dem Anfang der Datei.

**3.** Verfahren nach Anspruch 1,
**dadurch gekennzeichnet, dass** beim Durchführen des Interpretierens eine vorbestimmte Grundstruktur des Prozessors verwendet wird, wobei der Prozessor demnach mindestens eine Steuereinheit hat der ein Programmspeicher zugeordnet ist, mindestens ein Adressenpfadmodul, mindestens ein Datenpfadmodul und mindestens ein Speichermodul.

**4.** Verfahren nach Anspruch 3,
**dadurch gekennzeichnet, dass** das Auftreten einer arithmetischen Operation in den Definitionen von Variablen und Operationen und/oder Funktionen eine arithmetische Einheit in einem Datenpfadmodul signalisiert, wobei die operierten Variablen als Register in dem Datenpfadmodul interpretiert werden.

**5.** Verfahren nach Anspruch 3,
**dadurch gekennzeichnet, dass** die Operationen und/oder Funktionen eine Spezialoperation zum parallelen oder simultanen Durchführen von Operationen und/oder Funktionen umfasst, verbunden durch diese Spezialoperation, wobei das Auftreten dieser Spezialoperation in den Definitionen von Variablen und Operationen und/oder Funktionen signalisiert, dass der Prozessor mindestens dieselbe Anzahl arithmetische Einheiten umfassen soll, jede in einem Datenpfadmodul, wobei die operierten Variablen interpretiert werden als Register in dem jeweiligen Datenpfadmodul.


**Revendications**

**1.** Procédé de production d'un processeur de signaux numériques ayant une structure prédéterminée et des fonctions prédéterminées, comprenant les étapes qui consistent

- à déterminer une architecture d'au moins une partie du processeur,
- à réaliser une description d'agencement des circuits correspondants sur la base de l'architecture déterminée,
- à réaliser l'agencement des circuits correspondants sur la base de la description d'agencement,
- à traiter une puce de semiconducteurs en fonction de l'agencement,

**caractérisé**

- **en ce que**, dans la réalisation d'une description de l'agencement d'une partie du processeur, la structure de la partie du processeur est codée sous forme de définitions de variable comprenant les caractéristiques particulières de chaque variable, les variables indiquant des registres dans le processeur, et, en outre, sous forme d'opérations et/ou de fonctions qui doivent être effectuées par la partie du processeur en utilisant les variables comme arguments, et
- **en ce que** ces définitions de variables et d'opérations et/ou de fonctions sont interprétées pour former les registres et les unités respectifs exécutant les fonctions et des lignes connectant les registres et les unités.

**2.** Procédé selon la revendication 1, **caractérisé**

- **en ce que**, dans la réalisation de la description de l'agencement, les définitions et les opérations et/ou fonctions sont écrites sous la forme d'un fichier de texte, et
- **en ce que** le fichier de texte est interprété séquentiellement ou consécutivement, en partant du commencement du fichier.

**3.** Procédé selon la revendication 1, **caractérisé**

- **en ce que** les définitions de variables et d'opérations et/ou de fonctions sont réalisées pour essentiellement un processeur entier, et
- **en ce que**, lors de la réalisation de l'interprétation, une structure prédéterminée fondamentale du processeur est utilisée, le processeur ayant ainsi au moins une unité de commande associée à une mémoire de programme, au moins un module de chemin d'adresses, au moins un module de chemin de données et au moins un module de mémoire.

4. Procédé selon la revendication 3, **caractérisé en ce que** l'apparition d'une opération arithmétique dans les définitions de variables et des opérations et/ou fonctions signale une unité arithmétique dans un module de chemin de données, les variables sur lesquelles une opération est effectuée étant interprétées en tant que registres dans le module de chemin de données.

5. Procédé selon la revendication 3, **caractérisé en ce que** les opérations et/ou fonctions comprennent une opération spéciale pour exécuter en parallèle ou simultanément des opérations et/ou des fonctions reliées par cette opération spéciale, l'apparition de cette opération spéciale dans les définitions de variables et dans les opérations et/ou fonctions signalant que le processeur doit comporter au moins le même nombre d'unités arithmétiques, chacune dans un module de chemin de données, les variables sur lesquelles une opération est effectuée étant interprétées en tant que registres dans le module de chemin de données respectif.

## Behavioral Model Building

Fig. 1

# Fig. 2a

Textfile

**15**

Preprocessor

**15a** — Syntax check
Parser tree generation

Generation of
graphical representation — **15c**

Generation of
error messages

Generation of
executable code
for simulation — **15d**

**15b**

**21**

**21a** — Code generation,
ASCII-table, VHDL

**21b** — Core generation

Structural VHDL
Architecture Netlist    **21c** — VHDL-Model of core

VHDL-Lib

Link VHDL-Model
of CU, DP, AP, Mem etc.

**21d**

Implementation
Independent
VHDL

Generator
Information

Fig. 2b

```
┌──────────────┐
│    Start     │──── 201
└──────────────┘
       │
┌──────────────┐
│ Read Textfile│──── 203
└──────────────┘
       │
┌──────────────────────┐
│    Syntax check      │──── 205
│ Generate parser tree │
└──────────────────────┘
       │
       ▼
   209        No      ◇ Textfile ◇ ──── 207
              ◄───────  formally
┌──────────────┐        correct?
│Display error │              │ Yes
│  messages    │              ▼
└──────────────┘   ┌─────────────────────┐
       │           │ Generate graphical  │
┌──────────┐       │  representation of  │──── 213
│   Stop   │       │    architecture     │
└──────────┘       └─────────────────────┘
   211                        │
              No    ◇ Architecture ◇ ──── 215
            ◄──────  equal to desired?
┌──────────┐                  │ Yes
│   Stop   │──── 217          ▼
└──────────┘                231
```

235 / 231 / 221

**Extract information from textfile:**
Operations,
Registers, memory,
Connectivity

**Extract information from textfile:**
Map operations
on Instructions
Generate symbolic
microcode

**Convert textfile to C++-code:**
Serialize parallel operations
Add cycle count and
performance measurement
parameters
Add I/O,
asynchronous external control,
main program

**Generate VHDL-description of hardware** — 237

**Convert microcode to ASCII-table of "1" and "0" in VHDL-format** — 233

**Compile complete C++-program** — 223

239

**Combine description of hardware and microcode to complete VHDL-description**

**Link Fix Class Library (Behaviour models)** — 225

Stop

Stop

Stop

Fig. 3

INT_Z

INT_A

21

SI_X
EI_X
READY
DATA
ED

**Processor Core**

SO_X
OREQ_X
EO_X

RESET

MCL

Fig. 4

| Memn | ··· | Mem2 | Mem1 | | APn | 35 |

AP2

AP1

39

Control
**CU**
Status

External Control

Status

31

| DPn | ··· | DP2 | DP1 |

Pmem

33

Local Bus

37

I/O

I/O

I/O

# Fig. 5

EP 0 853 792 B1

**MemA**

W          R

**Sacc**

**Mareg**

*

**EO**
**SO**

**Oreg**

**Mereg**

**EI**
**SI**

**Ireg**

+

**Acc**

Fig. 6

Acc = Sacc + Ireg;

Fig. 7a

Fig. 7b

Acc ← + ● Sacc

● Ireg